# EUROPÄISCHE PATENTSCHRIFT

(11) **EP 2 637 488 B1**
(45) Veröffentlichungstag und Bekanntmachung des Hinweises auf die Patenterteilung: **28.03.2018**
(21) Anmeldenummer: 12001479.0
(22) Anmeldetag: 05.03.2012
(51) Int. Cl.: H05K 7/20

(54) **Klimagerät zur Kühlung von Elektronikgeräten oder Elektronikgeräteschränken mit Ausblasgitter**
Air conditioning device for cooling electronics components or electronics cabinets with outlet grill
Appareil de climatisation destiné au refroidissement d'appareils électroniques ou d'armoires d'instruments électroniques avec grille de soufflage

(43) Veröffentlichungstag der Anmeldung: 11.09.2013
(73) Patentinhaber: STULZ GmbH, D-22457 Hamburg (DE)
(72) Erfinder: Hülskamp, Stephan, 21220 Seevetal/Ramelsloh (DE); Beyer, Sebastian, 22844 Norderstedt (DE)
(74) Vertreter: Kossak, Sabine

(56) Entgegenhaltungen:
- WO-A1-2009/141610
- WO-A2-2008/039773
- US-A- 2 140 993
- US-A- 2 612 096

## Beschreibung

Gegenstand der Erfindung ist ein Klimagerät zum Kühlen von Luft für ein Elektronikgerät oder einen Elektronikgeräteschrank, aufweisend ein Gehäuse mit einer Vorderseite und einer der Vorderseite gegenüberliegenden Rückseite, mindestens einen Ventilator und einen Wärmetauscher, wobei der Ventilator Luft von der Rückseite ansaugt, durch den Wärmetauscher zur Vorderseite leitet und in radialer Richtung an der Vorderseite abgibt, wobei der Wärmetauscher mit einer externen Kühleinrichtung oder einer internen Kühleinrichtung zum Beaufschlagen des Wärmetauschers mit gekühltem Kühlmedium in Verbindung steht.

Für den sicheren Betrieb von Elektronikgeräten, wie zum Beispiel Servern insbesondere in Rechenzentren oder Fertigungsanlagen ist es notwendig, diese ausreichend zu kühlen. Die Kühlung erfolgt üblicherweise mit Klimageräten, die ausreichend Kühlluft bereit stellen, welche mit Hilfe von Ventilatoren zu den Elektronikgeräten und durch die Elektronikgeräte geleitet wird. Dabei nimmt die Kühlluft die Abwärme beziehungsweise Wärme der elektronischen Komponenten auf und regelt so die Betriebstemperatur der Elektronikgeräte. Ein besonderer Bedarf für solche Klimageräte besteht in Rechenzentren und in Fertigungsanlagen, in denen eine große Zahl von Elektronikgeräten untergebracht ist, um eine hohe Rechenleistung pro Raumeinheit gewährleisten zu können. In diesen Rechenzentren und Fertigungsanlagen werden die Elektronikgeräte üblicherweise in sogenannten Racks, Elektronikgeräteschränken mit standardisierten Rastermaßen, untergebracht. Die Racks weisen dabei häufig Raum für eine Vielzahl von dicht übereinander gestapelten Elektronikgeräten auf. Es besteht daher ein Bedarf, zuverlässig und dauerhaft eine ausreichende Menge Kühlluft bereit zu stellen, ohne dass hierfür ein großer Bauraum beansprucht wird.

In modernen Rechenzentren werden mehrere durch Gänge voneinander beabstandete Reihen bestehend aus zueinander benachbarten Racks in einem Raum angeordnet, wobei üblicherweise die Fronten der Racks einer ersten Reihe zu den Fronten der Racks der benachbarten Reihe ausgerichtet sind. Üblicherweise weisen die Fronten Lufteinlässe auf, über die kühle Luft zur Kühlung der Elektronikgeräte eingesaugt wird. Die Gänge, zu denen die Fronten mit den Lufteinlässen weisen, werden deshalb auch als "Kaltgang" oder "kühler Gang" bezeichnet. Die kühle Luft strömt durch die elektronischen Geräte, nimmt dabei die Wärme aus den Geräten auf und wird an der Rückseite der Elektronikgeräteschränke beziehungsweise Racks in den nächsten Gang wieder abgegeben. Dieser Gang wird deshalb als "warmer Gang" oder "Heißgang" bezeichnet. Entsprechend müssen Klimageräte vorhanden sein, die kühle Luft in die kalten Gänge leiten. Dieses kann beispielsweise herunter gekühlte Luft aus den "Heißgängen" sein.

Es ist bekannt, Klimageräte zwischen den Racks für die Elektronikgeräte wie zum Beispiel Servern anzuordnen. Die Luft aus den Klimageräten wird dabei senkrecht zur Front des Klimagerätes beziehungsweise der benachbarten Racks in den "Kaltgang" eingeblasen.

Nachteilig bei den Klimavorrichtungen aus dem Stand der Technik ist, dass die gekühlte Luft nicht optimal zu den zu kühlenden Elektronikgeräten geleitet wird. Hierdurch erfolgt eine Durchmischung von kalter und warmer Luft, die zu einem niedrigeren Wirkungsgrad der Klimageräte führt.

Zur Verbesserung der Luftführung werden daher teilweise Luftführungsbleche eingesetzt. Eine Variante von Luftführungsblechen ist beispielsweise aus der US 2006/0139877A1 bekannt. Luftführungsbleche werden an der Ausströmöffnung vor dem Ventilator angebracht und dienen dazu, die Luft umzuleiten und an den Fronten der Racks entlangzuführen. Der Nachteil dieser Ausführung ist, dass zusätzliche externe Bauteile an den Klimageräten in Form von Luftführungsblechen notwendig sind, die jeweils an die genaue Aufstellung und Geometrie angepasst werden müssen. Die Klimageräte sind für den jeweiligen Einsatzort ausgelegt und können nicht ohne Umbauten variabel für einen anderen Einsatzort verwendet werden.

Aus der WO 2009/141610 A1 ist eine Klimatisierungsvorrichtung zum Kühlen von Luft für Elektronikgeräteschränke bekannt. Die Klimatisierungsvorrichtungen sind so gestaltet, dass sie in bestehende Server-RACKS integriert werden können und mit möglichst wenig baulichen Veränderungen in einem Serverraum verwendet werden kann. Die Klimatisierungsvorrichtung wird dabei so angeordnet, dass Vorder- und Rückseite der Kühleinrichtung eine Fläche mit den benachbarten Elektronikgeräten bilden oder die Kühleinrichtung in einer versetzten Position eingebaut ist.

Die WO 2008/039773 A2 offenbart ein transportables Datenzentrum, das in einem Container platziert ist. In dem Container sind zwischen den Servern jeweils Ventilatoreinheiten platziert, die die erwärmte Luft ansaugen, über einen Wärmetauscher führen und gekühlt in den Mittelgang abgeben. Die US 2,140,993 A beschreibt ein Lüftungsgitter für ein Klimagerät. Das Lüftungsgitter soll möglichst einfach und kostengünstig zu fertigen sein.

Aufgabe der vorliegenden Erfindung ist es daher, ein Klimagerät zur Kühlung von Luft für Racks wie zum Beispiel Serverracks bereitzustellen, die einen hohen Wirkungsgrad haben, die Durchmischung von kalter und warmer Luft verringern und eine variable Aufstellung durch Vermeidung von externen Luftführungsblechen erlauben. Dabei soll die bereitgestellte Kühlluft möglichst direkt auf kurzem Wege vom Klimagerät zu den einzelnen Elektronikgeräten gelangen, auch wenn das Klimagerät als eigenständige, unabhängige Einheit (stand-alone-Gerät) ausgeführt ist.

Die Aufgabe wird erfindungsgemäß gelöst durch ein Klimagerät zum Kühlen von Luft für ein Rack oder dergleichen, aufweisend
- ein Gehäuse mit einer Vorderseite und einer der Vorderseite gegenüberliegenden Rückseite,
- mindestens einen Ventilator und
- einen Wärmetauscher,
wobei der Wärmetauscher mit einer externen Kühleinrichtung oder einer internen Kühleinrichtung zum Beaufschlagen des Wärmetauschers mit gekühltem Kühlmedium in Verbindung steht,
wobei der Ventilator Luft von der Rückseite ansaugt, durch den Wärmetauscher zur Vorderseite leitet und in radialer Richtung an der Vorderseite abgibt,
wobei an der Luftausblasöffnung ein Ausblasgitter (Strömungsgitter) angeordnet ist, durch das der Luftstrom geführt wird und die Luftausblasöffnung (7) sich in der Seitenwand des Klimagerätegehäuses befindet und der Ventilator (5) als ein Radialgebläse ausgeführt ist, das sich von der Vorderseite (3) des Klimageräts (1) nach außen hin erstreckt und eine axial in das Klimagerät (1) eintretende Luftströmung in radialer Richtung parallel zu einer Begrenzungsfläche der Vorderseite (3) ausleitet, dadurch gekennzeichnet, dass das Ausblasgitter senkrecht zueinander angeordnete Leitbleche aufweist, die parallel zur Strömungsrichtung angeordnet sind und eine Tiefe von 5 bis 30 mm, besonders bevorzugt von 15 bis 20 mm, haben.

Bevorzugte Ausführungsformen sind Gegenstand der Unteransprüche und nachfolgend beschrieben.

Die Ausleitung der gekühlten Luft aus dem Klimagerät in radialer Richtung bewirkt, dass der austretende Kühlluftstrom sich an den Oberflächen der benachbarten Elektronikgeräteschränkefronten entlang bewegt und sich an die Oberflächen anlegt. Dieser Effekt, dass sich die Luftströmung an die Fronten anlegt, ist nach dem Entdecker Henry Coanda als Coanda-Effekt bekannt. Hierdurch bleibt die kalte Luft stets nahe an den zu kühlenden Geräten und vermischt sich nicht oder nur wenig mit der im Kaltgang bereits befindlichen Luft. Ein solches Klimagerät, dass eine effektive Kühlung unter Einsatz des Coanda-Effekts ermöglicht ist in der EP 10 010 196.3 A beschreiben, auf deren Inhalt hiermit ausdrücklich Bezug genommen wird. Das erfindungsgemäße Klimagerät stellt eine Weiterentwicklung dieses Geräts dar.

Bei dem bisherigen Gerät wird die gekühlte Luft bedingt durch den Coanda-Effekt eng an den Fronten der Serverracks entlang geführt. Die Kaltluft verlässt dabei das Klimagerät in einem Raumwinkel (Strömungsöffnungswinkel) von ca. 20°, d.h. die Kaltluft wird immer noch, wenn auch in geringem Umfang in den Kaltgang eingeblasen und hier ggf. mit Warmluft vermischt. Durch das Ausblasgitter im erfindungsgemäßen Klimagerät wird der Strömungsöffnungswinkel auf Werte < 10°, bevorzugt <9° verringert. Die Kaltluft wird somit fast parallel zu den Fronten der Racks abgegeben und legt sich an die Serverschränke an. Eine zusätzliche Kaltgangeinhausung zur Verbesserung der Kühlung ist nicht mehr notwendig.

Durch das verbesserte Strömungsprofil wird auch die Strömungsgeschwindigkeit in weiterer Entfernung vom Klimagerät erhöht. Hierdurch verbessern sich zusätzlich die Kühlleistung und der Wirkungsgrad des erfindungsgemäßen Klimageräts.

Das erfindungsgemäße Klimagerät weist zur Verbesserung der Kühlleistung ein Ausblasgitter auf, das an der Luftausblasöffnung angeordnet ist. Der Luftstrom der Kaltluft, die das Klimagerät verlässt, wird durch das Gitter geführt, das als Strömungsgleichrichtergitter wirkt. Das Ausblasgitter hat senkrecht zueinander angeordnete Leitbleche, die parallel zur Strömungsrichtung, quasi in Strömungsrichtung angeordnet sind, wodurch nur eine sehr geringe Beeinträchtigung der Ausströmfläche bedingt ist. Das Ausblasgitter besitzt einen freien Querschnitt > 90% im Vergleich zu üblichen Abdeckungen oder Abdeckgittern die freie Querschnitte von etwa 70 % haben. Daraus resultieren geringe luftseitige Druckverluste und geringe Leistungsaufnahmen der Ventilatoren. Entsprechend weisen die erfindungsgemäßen Klimageräte bessere Energiewerte als herkömmliche Klimageräte auf.

Die Leitbleche haben bevorzugt eine Tiefe von 5 bis 30 mm, besonders bevorzugt von 10 bis 20 mm. Die Leitbleche des Ausblasgitters stehen in Gitterform senkrecht zueinander und bilden bevorzugt rechteckige, besonders bevorzugt quadratische, Gitteröffnungen. Die Gitteröffnungen haben bevorzugt eine Breite von 5 bis 30 mm, besonders bevorzugt 10-20 mm.

Das erfindungsgemäße Klimagerät weist bevorzugt ein bis fünf Ventilatoren, besonders bevorzugt drei bis vier Ventilatoren auf. Bevorzugt sind die Ventilatoren übereinander auf verschiedenen Höhen in einem Klimagerät angeordnet. In einer Ausführungsform werden bevorzugt Ventilatoren mit einem Ventilatordurchmesser von 220 bis 355 mm, besonders bevorzugt 310 mm oder 355 mm, eingesetzt.

Die erfindungsgemäßen Klimageräte können in Rechenzentren mit oder ohne Doppelboden eingesetzt werden. Bevorzugt werden die Klimageräte neben den Racks, Elektronikgeräteschränken mit bevorzugt standardisierten Abmessungen, platziert.

Das erfindungsgemäße Klimagerät wird bevorzugt neben ein oder mehrere Racks oder zwischen mindestens zwei Racks platziert. Abhängig davon, ob Racks nur auf einer Seite neben dem Klimagerät oder auf beiden Seiten neben dem Klimagerät platziert sind, wird die Luft radial zu einer oder zu beiden Seiten aus dem Klimagerät geführt. Das Klimagerät wird dabei bevorzugt so neben oder zwischen die Racks platziert, dass der vordere Bereich des Klimagerätes, in dem der oder die Ventilatoren angeordnet sind, vor die Fronten der Racks vorgezogen ist. Im eingebauten Zustand steht das Klimagerät im Vergleich zu den benachbarten Racks somit nach vorne zur Vorderseite vorgezogen. Aufgrund dieser Platzierung streicht die gekühlte Luft aus den Ventilatoren, die radial abgeben wird, an den Fronten der Elektronikgeräteschränke entlang und legt sich aufgrund des Coanda-Effekts an die Fronten an. Die Kaltluft wird über eine oder mehrere Ausblasöffnungen abgegeben, die sich in der Seitenwand des Klimagerätgehäuses befinden. Das Ausblasgitter ist im erfindungsgemäßen Klimagerät bevorzugt so angeordnet, dass es die Ausblasöffnung(en) vollständig bedeckt.

Der Wärmetauscher des erfindungsgemäßen Klimageräts steht mit einer externen Kühleinrichtung oder einen internen Kühleinrichtung zum Beaufschlagen des Wärmetauschers mit gekühltem Kühlmedium in Verbindung. Solche Kühleinrichtungen sind beispielweise Kompressorkühlungen mit einem Kältemittel, Kaltwasserkühlungen, Systeme mit Kühlwasserkreislauf oder Systeme mit indirekter freier Kühlung. Das erfindungsgemäße Klimagerät weist bevorzugt mindestens eine Leitung zum Verbinden des Wärmetauschers, mit einer zentralen Kühleinrichtung auf. Bevorzugt weist der Wärmetauscher im erfindungsgemäßen Klimagerät mehrere jeweils individuell regelbare Wärmetauschersegmente auf verschiedenen Höhen aufweist.

In einer Ausführungsform weist das Klimagerät ferner einen vorspringenden Rahmen auf, in dem der oder die Ventilatoren angeordnet sind.

Bevorzugt ist der durch die Ventilatoren verursachte Luftvolumenstrom regelbar, insbesondere für jeden Ventilator im Klimagerät individuell regelbar.

Die Erfindung wird anhand der nachfolgenden Figuren beispielhaft näher erläutert.

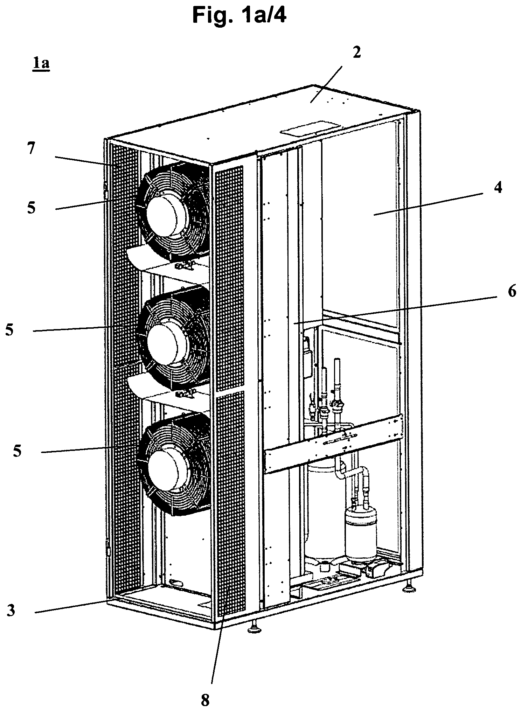

Es zeigt
- Figur 1a: eine perspektivische Darstellung eines erfindungsgemäßen Klimageräts,
- Figur: 1b einen Draufsicht auf das Ausblasgitters des Klimageräts gemäß Fig. 1a,
- Figur 1 c: eine perspektivische Ansicht des Ausblasgitters gemäß Figur 1b,
- Figur 2: eine Draufsicht auf ein Klimagerät, das zwischen mehreren Racks eingebaut ist,
- Figur 3: den Strömungsöffnungswinkel mit und ohne erfindungsgemäßes Klimagerät und
- Figur 4: die Strömungsgeschwindigkeit in verschiedenen Entfernungen vom erfindungsgemäßen Klimagerät.

Figur 1a zeigt eine Ausführungsform des erfindungsgemäßen Klimageräts 1. Das Klimagerät weist ein Gehäuse 2 mit einer Vorderseite 3 und einer Rückseite 4 auf. An der Vorderseite 3 des Klimageräts 1 sind Ventilatoren 5 angeordnet. Das Klimagerät 1 umfasst zudem einen Wärmetauscher 6. Luft wird von der Rückseite 4 mittels der Ventilatoren 5 in das Klimagerät 1 gesogen, strömt an dem mit Kühlmedium beaufschlagten Wärmetauscher 6 entlang und wird gekühlt. Die Luft verlässt das Klimagerät in radialer Richtung durch die Luftausblasöffnungen 7. Vor den Luftausblasöffnungen 7 sind die Ausblasgitter 8 angeordnet.

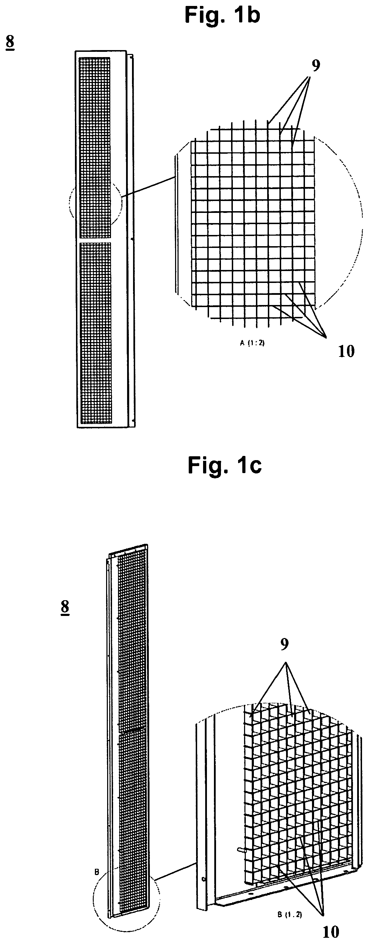

Figur 1b zeigt eine Draufsicht auf das Ausblasgitter 8, sowie einen vergrößerten Ausschnitt. Die in der Figur von oben nach unten verlaufenden senkrechten Leitbleche 9 stehen dabei senkrecht auf den von rechts nach links verlaufenden waagerechten Leitblechen 10, so das quadratische Gitteröffnungen entstehen. Die waagerechten und senkrechten Leitbleche sind dabei, wie aus Figur 1c erkennbar, in Strömungsrichtung der gekühlten Luft angeordnet.

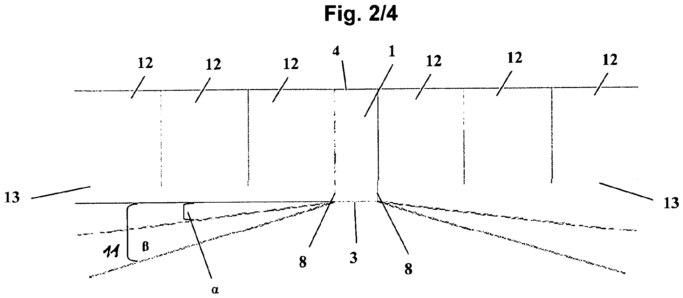

Das erfindungsgemäße Klimagerät 1 wird bevorzugt zwischen mehrere Serverracks 12 eingebaut, wie in Figur 2 dargestellt. Die gekühlte Luft verlässt das erfindungsgemäße Klimagerät in einen Strömungsöffnungswinkel α von maximal 8,5° und legt sich somit an die Fronten 13 der Racks 12 an. Zum Vergleich sind der Strömungsöffnungswinkel β von Geräten ohne Ausblasgitter, sowie der Strömungsöffnungswinkel 0° dargestellt.

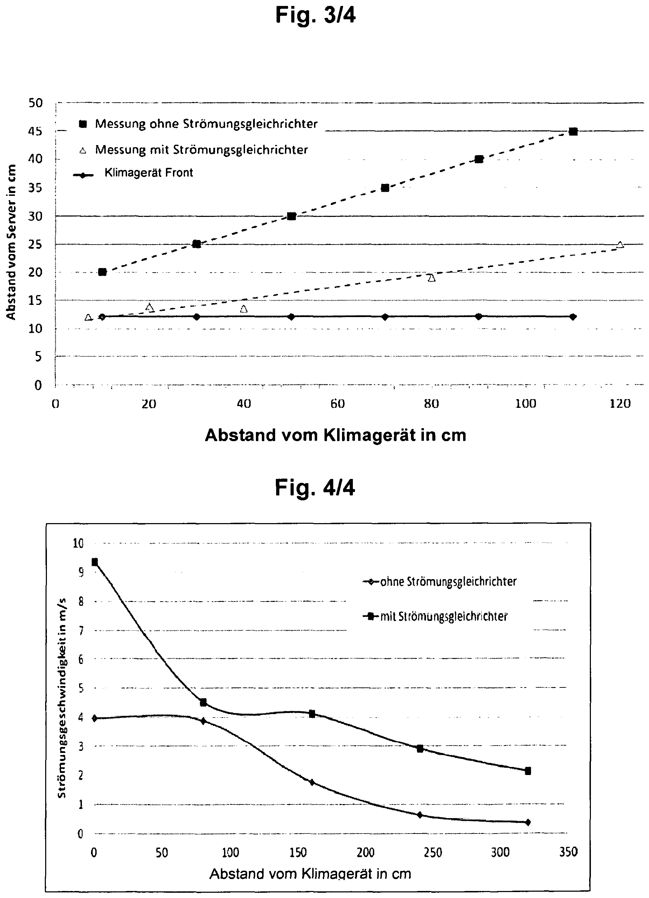

Figur 3 zeigt eine grafische Darstellung des Strömungsöffnungswinkels mit und ohne Ausblasgitter. Die Graphik zeigt den Abstand vom Klimagerät im Verhältnis zum Abstand von der Serverfront. Es ist erkennbar, dass sich durch das Ausblasgitter des erfindungsgemäßen Klimageräts der Ausblaswinkel fast halbieren lässt.

Figur 4 zeigt die Strömungsgeschwindigkeit der gekühlten Luft in Abhängigkeit vom Abstand vom Klimagerät. Durch das Ausblasgitter wird die Strömungsgeschwindigkeit insbesondere bei größerer Entfernung vom Klimagerät deutlich erhöht. Das erfindungsgemäße Klimagerät erreicht somit einen höheren Wirkungsgrad als ein Klimagerät ohne Ausblasgitter.

### Bezugszeichenliste

- 1: Klimagerät
- 2: Gehäuse
- 3: Vorderseite
- 4: Rückseite
- 5: Ventilator
- 6: Wärmetauscher
- 7: Luftausblasöffnung
- 8: Ausblasgitter
- 9: senkrechtes Leitblech
- 10: waagerechtes Leitblech
- 11: Strömungsöffnungswinkel
- 12: Elektronikgeräteschrank
- 13: Fronten

## Patentansprüche

1. Klimagerät (1) zum Kühlen von Luft für einen Elektronikgeräteschrank (12) oder dergleichen, aufweisend
- ein Gehäuse (2) mit einer Vorderseite (3) und einer der Vorderseite gegenüberliegenden Rückseite (4),
- mindestens einen Ventilator (5) und
- einen Wärmetauscher (6),
wobei der Wärmetauscher (6) mit einer externen Kühleinrichtung oder einer internen Kühleinrichtung zum Beaufschlagen des Wärmetauschers (6) mit gekühltem Kühlmedium in Verbindung steht,
wobei der Ventilator (5) Luft von der Rückseite (4) ansaugt, durch den Wärmetauscher (6) zur Vorderseite (3) leitet und in radialer Richtung an der Vorderseite (3) abgibt,
an einer Luftausblasöffnung (7) ein Ausblasgitter (8) angeordnet ist, durch das der Luftstrom geführt wird und die Luftausblasöffnung (7) sich in der Seitenwand des Klimagerätegehäuses befindet und der Ventilator (5) als ein Radialgebläse ausgeführt ist, dass sich von der Vorderseite (3) des Klimageräts (1) nach außen hin erstreckt und eine axial in das Klimagerät (1) eintretende Luftströmung in radialer Richtung parallel zu einer Begrenzungsfläche der Vorderseite (3) ausleitet,
**dadurch gekennzeichnet, dass** das Ausblasgitter (8) senkrecht zueinander angeordnete Leitbleche (9,10) aufweist, die parallel zur Strömungsrichtung angeordnet sindund die Leitbleche (9,10) eine Tiefe von 5 bis 30 mm haben..

2. Klimagerät (1) nach Anspruch1, **dadurch gekennzeichnet, dass** die waagerechten (10) und senkrechten Leitbleche (9) rechteckige, bevorzugt quadratische, Gitteröffnungen bilden.

3. Klimagerät (1) nach Anspruch nach 1, **dadurch gekennzeichnet, dass** das Ausblasgitter (8) die Ausblasöffnung (7) vollständig bedeckt.

4. Klimagerät (1) nach einem der vorhergehenden Ansprüche, **dadurch gekennzeichnet, dass** die Leitbleche (9,10) eine Tiefe von 10 bis 20 mm haben.

5. Klimagerät (1) nach einem der vorhergehenden Ansprüche, **dadurch gekennzeichnet, dass** das Klimagerät (1) mehrere zueinander beabstandete auf verschiedenen Höhen angeordnete Ventilatoren (5) aufweist.

6. Klimagerät (1) nach einem der vorhergehenden Ansprüche, **dadurch gekennzeichnet, dass** das Klimagerät (1) mindestens einen Temperatursensor zum Erfassen der Temperatur der einströmenden und/oder ausströmenden Luft an der Rückseite eines zu kühlenden Racks, an der Rückseite des Klimagerätes oder an der Austrittsseite des Wärmetauschers aufweist.

7. Klimagerät (1) nach einem der vorhergehenden Ansprüche, **dadurch gekennzeichnet, dass** das Klimagerät mehrere Temperatursensoren aufweist, die auf verschiedenen Höhen die Temperaturen erfassen und die erfassten Temperaturen zur individuelle Regelung der Luftvolumenströme und/oder der Wärmetauschersegmente verwenden.

## Claims

1. An air conditioning device (1) used to cool air for an electronic equipment rack (12) or the equivalent, comprising:
- a housing (2) having a front side (3) and, opposite the front side, a back side (4),
- at least one fan (5) and
- a heat exchanger (6),
wherein the heat exchanger (6) is connected with an external cooling apparatus or an internal cooling apparatus in order to supply the heat exchanger (6) with chilled coolant,
and wherein the fan (5) draws air in from the back side (4), conducts it through the heat exchanger (6) to the front side (3), and emits the air in a direction radial to the front side (3);
an outlet grille (8), through which the airflow is guided, is arranged on an air outlet opening (7), which is located on the sidewall of the housing for the air conditioning device, and the fan (5) is designed as a radial blower, which extends outward from the front side (3) of the air conditioning device (1) and discharges the airflow, which enters the air conditioning device (1) from a direction axial to the air conditioning device (1), in a radial direction that is parallel to a peripheral surface on the front side (3),
**characterized in that** the outlet grille (8) comprises baffle plates (9, 10), which are arranged vertically with respect to one another and are arranged to be parallel to the direction of flow, said plates (9, 10) having a depth of from 5 to 33 mm.

2. The air conditioning device (1) according to claim 1, **characterized in that** the horizontal (10) and the vertical baffle plates (9) form rectangular, preferably square, grille openings.

3. The air conditioning device (1) according to claim 1, **characterized in that** the outlet grille (8) completely covers the outlet opening (7).

4. The air conditioning device (1) according to any of the preceding claims, **characterized in that** the baffle plates (9, 10) have a depth of from 10 to 20 mm.

5. The air conditioning device (1) according to any of the preceding claims, **characterized in that** the air conditioning device (1) comprises a plurality of fans (5), which are arranged at various heights and at a distance from one another.

6. The air conditioning device (1) according to any of the preceding claims, **characterized in that**, in order to detect the temperature of the air flowing in and/or out, the air
conditioning device (1) comprises at least one temperature sensor on the back side of the rack being cooled, on the back side of the air conditioning device, or on the outlet side of the heat exchanger.

7. The air conditioning device (1) according to any of the preceding claims, **characterized in that** the air conditioning device comprises a plurality of temperature sensors, which measure the temperature at various heights and use the temperatures detected in order to individually control the volumetric airflows and/or the heat exchanger segments.

## Revendications

1. Appareil de climatisation (1) destiné au refroidissement d'air pour une armoire d'instruments électroniques (12) ou un dispositif analogue, présentant
- un boîtier (2) avec une face avant (3) et une face arrière (4) opposée à la face avant,
- au moins un ventilateur (5) et
- un échangeur de chaleur (6),
sachant que l'échangeur de chaleur (6) est relié à un dispositif de refroidissement externe ou un dispositif de refroidissement interne destiné à alimenter l'échangeur de chaleur (6) avec un fluide frigorigène refroidi,
sachant que le ventilateur (5) aspire de l'air depuis la face arrière (4), le fait passer dans l'échangeur de chaleur (6), en direction de la face avant (3), et le distribue dans la direction radiale sur la face avant (3),
sachant qu'il est prévu sur une ouverture de soufflage d'air (7), une grille de soufflage (8) à travers laquelle est guidé le flux d'air, et l'ouverture de soufflage d'air (7) se situe dans la paroi latérale du boîtier de l'appareil de climatisation, et le ventilateur (5) est réalisé sous forme de soufflante radiale qui s'étend de la face avant (3) de l'appareil de climatisation (1) vers l'extérieur et dirige vers l'extérieur, dans la direction radiale, parallèlement à une surface de limitation de la face avant (3), un flux d'air entrant axialement dans l'appareil de climatisation (1),
**caractérisé en ce que** la grille de soufflage (8) présente des tôles de guidage (9, 10) qui sont disposées perpendiculairement les unes aux autres et sont parallèles au sens d'écoulement, et que les tôles de guidage (9, 10) ont une profondeur allant de 5 à 30 mm.

2. Appareil de climatisation (1) selon la revendication 1, **caractérisé en ce que** les tôles de guidage horizontales (10) et verticales (9) forment des ouvertures de grille rectangulaires, de préférence carrées.

3. Appareil de climatisation (1) selon la revendication 1, **caractérisé en ce que** la grille de soufflage (8) recouvre complètement l'ouverture de soufflage (7).

4. Appareil de climatisation (1) selon une des revendications précédentes, **caractérisé en ce que** les tôles de guidage (9, 10) ont une profondeur allant de 10 à 20 mm.

5. Appareil de climatisation (1) selon une des revendications précédentes, **caractérisé en ce que** l'appareil de climatisation (1) présente plusieurs ventilateurs (5) espacés les uns des autres et disposés à des hauteurs différentes.

6. Appareil de climatisation (1) selon une des revendications précédentes, **caractérisé en ce que** l'appareil de climatisation (1) présente au moins un capteur de température destiné à mesurer la température de l'air entrant et/ou sortant, sur la face arrière d'une baie à refroidir, sur la face arrière de l'appareil de climatisation ou sur le côté sortie de l'échangeur de chaleur.

7. Appareil de climatisation (1) selon une des revendications précédentes, **caractérisé en ce que** l'appareil de climatisation (1) présente plusieurs capteurs de température qui mesurent les températures à des hauteurs différentes et utilisent les températures mesurées pour la régulation individuelle des débits d'air volumiques et/ou des segments de l'échangeur de chaleur.
